# EUROPÄISCHE PATENTSCHRIFT

(11) **EP 2 144 026 B1**
(45) Veröffentlichungstag und Bekanntmachung des Hinweises auf die Patenterteilung: **13.04.2016**
(21) Anmeldenummer: 08011247.7
(22) Anmeldetag: 20.06.2008
(51) Int. Cl.: F27B 7/00, F27B 5/04, F27B 5/14, F27B 5/16, F27D 7/04, C23C 16/455, H01L 31/00, H01L 21/00

(54) **PROZESSVORRICHTUNG UND VERFAHREN ZUM PROZESSIEREN VON GESTAPELTEN PROZESSGÜTERN**
PROCESSING DEVICE AND METHOD FOR PROCESSING STACKED GOODS
DISPOSITIF ET PROCEDÉ DE TRAITEMENT ET TRAITEMENT DE MARCHANDISES DE TRAITEMENT EMPILÉES

(43) Veröffentlichungstag der Anmeldung: 13.01.2010
(73) Patentinhaber: Probst, Volker, 14089 Berlin (DE)
(72) Erfinder: Probst, Volker, 14089 Berlin (DE)
(74) Vertreter: Metten, Karl-Heinz

(56) Entgegenhaltungen:
- EP-A- 1 643 199
- WO-A-2007/053016
- GB-A- 1 419 308
- JP-A- 5 157 461
- JP-A- 10 197 166
- JP-A- 62 131 188

## Beschreibung

Die Erfindung betrifft eine Prozessvorrichtung zum Prozessieren von gestapelten Prozessgütern, insbesondere bei mittleren bis hohen Temperaturen, welche eine evakuierbare Prozesskammer zur Aufnahme eines Prozessgases, eine Gasfördereinrichtung zum Erzeugen eines Gasströmungskreislaufes in der Prozesskammer und eine Heizeinrichtung zum Aufheizen des durch die Prozesskammer strömenden Gases umfasst.

Solche Vorrichtungen sind in GB1411938 und WO200/7053016 beschrieben.

Bei einer bekannten Prozessvorrichtung dieser Art kann es sich um einen Diffusionsofen mit einer durch ein Quarzrohr definierten Prozesskammer handeln, welcher beispielsweise bei der Herstellung von Dünnschichtsolarzellen vom CIS-Typ zum Einsatz kommt. Insbesondere dient der bekannte Diffusionsofen dazu, auf den Prozessgütern, z.B. Glassubstraten, die mit metallischen Precursorn, wie z.B. Kupfer, Indium und/oder Gallium, vorbeschichtet sind, mit Hilfe von selen- und/oder schwefelhaltigen Prozessgasen, wie z.B. H₂Se- oder H₂S-Gas, eine Chalcopyrit-Halbleiterschicht, die beispielsweise die Absorberschicht einer Solarzelle bilden kann, herzustellen.

Zu diesem Zweck wird ein zu prozessierender und mit einer Precursor-Beschichtung versehener Substratstapel in das Quarzrohr eingeführt. Nach dem Verschließen des Quarzrohrs wird dieses so oft evakuiert und mit Inertgas befüllt, bis eine gewünschte Reinheit bezüglich Restsauerstoff und Restfeuchte erreicht ist. Anschließend wird das Prozessgas H₂Se mit einem inerten Trägergas in einer gewünschten Konzentration und bis zu einem gewünschten Druck eingelassen. Außerdem wird die Heizeinrichtung, eine um das Quarzrohr herum angeordnete Mantelheizung, eingeschaltet und so gesteuert, dass ein gewünschtes Temperaturprofil auf den Substraten erzeugt wird.

Nach einer vorgegebenen Reaktionszeit bei einer Temperatur zwischen 350°C und 450°C wird das Quarzrohr evakuiert. Anschließend wird ein Gemisch aus H₂S und inertem Trägergas eingelassen und die Temperatur auf etwa 450°C bis 550°C erhöht. Nach einer vorgegebenen Reaktionszeit erfolgt dann eine Abkühlung der Anordnung bis auf Raumtemperatur sowie eine Eliminierung der toxischen Prozessgase mittels verschiedener Pump-Spül-Zyklen. Nach einer Belüftung des Quarzrohrs können die Substrate mit den zu Chalcopyrit-Halbleitern reagierten Dünnschichten entnommen werden.

Bei der so erzeugten Halbleiterschicht kann es sich um eine Cu(In, Ga)(Se, S)₂-Schicht mit einem typischen Ga-Konzentrationsanstieg zu einer Rückelektrode hin und einem S-Konzentrationsanstieg zur Oberfläche hin handeln. Die Halbleiterschicht liegt praktisch mehrphasig vor mit einem graduierten Phasenübergang und einem graduierten Bandabstand.

Als problematisch erweist sich bei der bekannten Prozessvorrichtung die ungünstige zylindersymmetrische Infrarotstrahlungsgeometrie und die Abschattung der Infrarot-Strahlung im Substratstapel. Die so erzeugten thermischen Inhomogenitäten können nur reduziert werden, indem die Aufheiz- und Abkühlraten klein gehalten werden. Dies erhöht die minimal mögliche Prozesszeit signifikant und schränkt somit die Prozesskapazität deutlich ein. Auch verbleibt eine nicht unerhebliche Streuung des Prozessergebnisses über den Stubstratstapel.

Die evakuierbare Prozesskammer wird durch ein Quarzrohr gebildet, weil gängige Vakuumkammermaterialien aus Metalllegierungen bestehen und Metalle sowie deren Legierungen in Selen- und Schwefeldampf sowie in H₂Se- und H₂S-Gas nicht beständig sind, sondern korrodieren. Die Korrosionsprodukte gelangen als Flitter und Feinstaub an den Chalcopyrit-Halbleiter und schädigen diesen durch elektrische Kurzschlüsse und als tiefe Störstellen.

Außerdem lässt sich eine durch ein Quarzrohr gebildete Prozesskammer aus fertigungstechnischen Gründen nur unter Aufbringung eines erheblichen wirtschaftlichen Mehraufwandes mit einem größeren Durchmesser als 80 cm herstellen. Die Größe der in einer solchen Anlage zu prozessierenden Substrate ist folglich limitiert.

Der Erfindung liegt die Aufgabe zugrunde, eine Prozessvorrichtung der eingangs genannten Art zu schaffen, die sich nicht nur durch eine verbesserte Wirtschaftlichkeit auszeichnet, sondern auch eine homogenere Schichtbildung ermöglicht.

Zur Lösung der Aufgabe ist eine Prozessvorrichtung mit den Merkmalen des Anspruchs 1 vorgesehen.

Die evakuierbare Prozesskammer der erfindungsgemäßen Prozessvorrichtung umfasst eine Temperiereinrichtung, um zumindest einen Teilbereich einer Wand der Prozesskammer auf einer vorgegebenen Temperatur zu halten. Die Temperiereinrichtung kann beispielsweise durch die Prozesskammerwand verlaufende Kanäle oder an einer Außenseite der Prozesskammer angebrachte, z.B. aufgeschweißte, mäanderförmig verlaufende Rohrleitungen umfassen, durch die ein Temperierfluid, z.B. Heißöl, strömt.

Durch die Temperiereinrichtung kann die Prozesskammerwand auf einer Temperatur gehalten werden, bei welcher das Material der Prozesskammerwand auch unter Einfluss der Prozessgasatmosphäre nicht korrodiert. Beispielsweise ist es bekannt, dass ein Korrosionsangriff deutlich mit der Temperatur ansteigt und bei Temperaturen im Bereich unter 250°C Edelstahl in einer selen- oder schwefelhaltigen Prozessgasatmosphäre kaum merklich korrodiert. Aufgrund der bekannten Dampfdruckkurven für Selen und Schwefel ist nicht zu erwarten, dass Selen bzw. Schwefel unter den Prozessbedingungen an den temperierten Wänden der Prozesskammer kondensiert. Durch diese Maßnahmen ist sichergestellt, dass die Prozesskammerwand dem Typus eines Heißwand-Reaktors zuzuordnen ist, der langzeitstabil ist und daher keine prozess-schädigenden Partikel abgibt. Des Weiteren ist durch die Temperierung sichergestellt, dass der Prozess sehr gut kontrollierbar ist, da im allgemeinen dampf- oder gasförmige Bestandteile des Prozessgases und im besonderen Selen oder Schwefel - beispielsweise als Dissoziationsprodukte von H₂Se oder H₂S - während des Prozessablaufes weder unkontrollierbar herauskondensiert werden noch unkontrollierbar wieder in den Prozess zurückgeführt werden.

Die Temperierung der Prozesskammerwand ermöglicht es letztlich, die Prozesskammer nicht aus einem Quarzrohr, sondern aus einem metallischen Material, wie z.B. Edelstahl, zu bilden, was erhebliche Freiheiten bei der Gestaltung und insbesondere Dimensionierung der Prozesskammer schafft.

Darüber hinaus lässt sich eine aus einem Metallmaterial gebildete Prozesskammer nicht nur bei gleicher Prozessierkapazität, sondern vor allem auch bei einem größeren Kammervolumen mit einem geringeren wirtschaftlichen Aufwand als ein Quarzrohr herstellen. Während sich Quarzrohr-Diffusionsöfen nur mit einem Durchmesser von bis zu 80 cm fertigen lassen, kann eine aus einem Metallmaterial gebildete Prozesskammer durch eine entsprechende Erhöhung und Verbreiterung vergleichsweise leicht an größere Prozessgutformate, d.h. Substratflächen, angepasst werden.

Die erfindungsgemäße Prozessvorrichtung umfasst ferner eine Gasfördereinrichtung zum Erzeugen eines Gasströmungskreislaufes in der Prozesskammer und eine in dem von der Gasfördereinrichtung erzeugten Gasströmungskreislauf angeordnete Heizeinrichtung zum Aufheizen des durch die Prozesskammer strömenden Gases. Die Heizeinrichtung ist mit anderen Worten innerhalb der Prozesskammer angeordnet, sodass auf eine außerhalb der Prozesskammer liegende Wärmequelle, z.B. Infrarotstrahlungsquelle, zur Erwärmung des Prozessgases verzichtet werden kann. Die Prozesskammer braucht somit nicht hinsichtlich Infraroteinstrahlung optimiert zu werden, was die Konstruktion der Prozesskammer erheblich vereinfacht und außerdem ebenfalls die Verwendung eines Metallmaterials zur Herstellung der Prozesskammer ermöglicht.

Zusätzlich zu der Gasfördereinrichtung weist die erfindungsgemäße Prozessvorrichtung ferner eine Gasleiteinrichtung auf, die den Prozessgutstapel aufnimmt und die in der Prozesskammer derart angeordnet ist, dass mindestens ein Teil des erzeugten Gasströmungskreislaufes durch die Gasleiteinrichtung hindurch verläuft. Die Gasfördereinrichtung und die Gasleiteinrichtung sorgen einerseits für ein besonders homogenes Aufheizen und Abkühlen des Prozessgutstapels durch erzwungene Konvektion und andererseits für eine besonders homogene Gasverteilung und dadurch letztlich besonders homogene Schichtbildung, z.B. eines Chalcopyrit-Halbleiters, auf den Prozessgütern, z.B. Glassubstraten.

Außerdem ermöglicht die Kombination von Gasfördereinrichtung, Gasleiteinrichtung und Heizeinrichtung eine erhöhte Aufheiz- und Abkühlgeschwindigkeit, wodurch kürzere Prozesszeiten und somit ein höherer Durchsatz von Prozessgütern möglich ist.

Dadurch, dass die erfindungsgemäße Prozessvorrichtung zum Prozessieren von Stapeln von Prozessgütern ausgelegt ist, d.h. also für einen sogenannten Batch-Betrieb, weist die Prozessvorrichtung im Vergleich zu reinen Inline-Anlagen eine höhere Kompaktheit, eine einfachere Wartung und Zugänglichkeit sowie eine geringere Komplexität auf.

Vorteilhafte Ausbildungen der Erfindung sind den Unteransprüchen, der Beschreibung und der Zeichnung zu entnehmen.

Gemäß einer ersten Ausführungsform ist an der Innenseite der Prozesskammerwand ein thermisches Isolationsmaterial vorgesehen, das unter Prozessbedingungen vorzugsweise reaktionsbeständig ist. Das Isolationsmaterial bildet zum einen zusätzlichen Schutz der Prozesskammerwand, z.B. vor Korrosion, und schafft zum anderen eine gewisse thermische Entkopplung der Prozesskammerwand von der in der Prozesskammer befindlichen Gasatmosphäre, sodass sich die Temperatur der Gasatmosphäre genauer steuern lässt. Die thermische Entkopplung beruht im Wesentlichen auf der geringen spezifischen Wärmekapazität und der geringen thermischen Leitfähigkeit, wie sie typisch für Isolationsmaterialien ist. Außerdem verhindert das thermische Isolationsmaterial, dass die Prozesskammerwand durch heißes Prozessgas über die vorgegebene Temperatur hinaus erwärmt wird oder der Wärmeaustrag zu groß wird. Das Thermische Isolationsmaterial ist insbesondere bei erzwungener Konvektion durch die Gasfördereinrichtung vorteilhaft, weil so der Wärmeaustrag aufgrund eines ansonsten guten Wärmeübergangs deutlich eingedämmt wird.

Bei dem Isolationsmaterial kann es sich beispielsweise um eine Keramik, eine Glaskeramik, Graphit, einschließlich eines Faserstoffes, wie z.B. Carbon Fiber Inforced Carbon (CFC), oder einen keramikfaserhaltigen Isolationsstoff, z.B. bestehend aus SiO₂- und Al₂O₃-Fasern, handeln.

Gemäß einer weiteren Ausführungsform weist die Gasleiteinrichtung mindestens eine obere Trennplatte, die einen ersten Kammerbereich in der Prozesskammer oberhalb der den Prozessgutstapel aufnehmenden Gasleiteinrichtung definiert, und eine untere Trennplatte auf, die einen zweiten Kammerbereich in der Prozesskammer unterhalb der den Prozessgutstapel aufnehmenden Gasleiteinrichtung definiert. Zusätzlich kann die Gasleiteinrichtung auch zwei seitliche Trennplatten aufweisen.

Bevorzugt weist die Gasleiteinrichtung zumindest eine Verteilervorrichtung zur flächig gleichmäßigen Verteilung der Gasströmung auf, wobei der Prozessgutstapel vorzugsweise stromabwärts von der Verteilervorrichtung angeordnet ist. Bei der Verteilervorrichtung kann es sich beispielsweise um eine Platte handeln, die mit Schlitzen und/oder Löchern versehen ist. Die Verteilervorrichtung und die Gasleiteinrichtung bestehen vorzugsweise aus einem reaktionsbeständigen Material, wie z.B. aus einer Glaskeramik, Siliziumkarbid oder Siliziumnitrid.

Je nach Verwendung der Art der Prozessgase können statt der hier vorgeschlagenen reaktionsbeständigen Materialien auch andere, wie z.B. Metalle oder Stähle, eingesetzt werden, wenn diese in den Prozessgasen beständig sind.

Ähnlich wie die Prozesskammerwand können auch die Oberflächen der Gasleiteinrichtung mit einem thermischen Isolationsmaterial versehen sein, welches unter Prozessbedingungen vorzugsweise reaktionsbeständig ist. Auf diese Weise ist auch die Gasleiteinrichtung zumindest weitgehend von der Gasatmosphäre in der Prozesskammer thermisch entkoppelt, sodass die Prozessvorrichtung, insbesondere im dynamischen Fall einer Temperatur-Solländerung, insgesamt eine geringere thermische Masse aufweist, wodurch sich die Temperatur des Prozessgases in der Prozesskammer noch schneller und genauer steuern lässt. Durch seine Reaktionsbeständigkeit gegenüber reaktiven Bestandteilen des Prozessgases bildet das Isolationsmaterial außerdem einen zusätzlichen Schutz für die Gasleiteinrichtung, z.B. vor Korrosion.

Gemäß einer weiteren Ausführungsform umfasst die Gasfördereinrichtung wenigstens einen Ventilator, der vorzugsweise ein reaktionsbeständiges Material aufweist. Der Ventilator ist in verschiedenen Ausführungsformen vorstellbar und nicht auf das in den Figuren gezeigte Prinzip beschränkt. Wichtig ist, dass der Ventilator zur Förderung von Prozessgasen möglichst effizient geeignet ist. Der Ventilator kann an einer Antriebswelle befestigt sein, die in die Prozesskammer hineinreicht und die vorzugsweise ebenfalls ein reaktionsbeständiges Material aufweist. Durch die Verwendung des reaktionsbeständigen Materials sind auch der Ventilator und/oder die Antriebswelle vor einem Angriff durch reaktive Bestandteile des Prozessgases und insbesondere vor Korrosion geschützt.

Vorteilhafterweise ist der Ventilator im Bereich einer der Stirnseiten des Prozessgutstapels angeordnet. Diese Anordnung des Ventilators trägt zu einer besonders homogenen Durchströmung des Prozessgutstapels mit Prozessgas und somit zu einer besonders homogenen Schichtabscheidung und Schichtreaktion bei.

Um die Strömungsgeschwindigkeit und die Homogenität der Gasströmung noch weiter zu erhöhen, ist vorteilhafterweise ein weiterer Ventilator im Bereich der anderen Stirnseite des Prozessgutstapels angeordnet. Bei dieser Anordnung von zwei Ventilatoren ist vorzugsweise der eine Ventilator so ausgebildet, dass er das Prozessgas in den Prozessgutstapel hineinfördert, während der andere Ventilator das Prozessgas aus dem Prozessgutstapel hinausfördert. Der eine Ventilator arbeitet mit anderen Worten im sogenannten Schub-Betrieb, während der andere im Saug-Betrieb arbeitet.

Bei dem reaktionsbeständigen Material des Ventilators bzw. der Antriebswelle kann es sich beispielsweise um ein Keramikmaterial, wie z.B. Siliziumnitrid oder Siliziumkarbid, handeln.

Vorzugsweise lässt sich der Antrieb des Ventilators bzw. lassen sich die Antriebe der Ventilatoren auch in umgekehrter Drehrichtung betreiben, sodass der Gasströmungskreislauf umgekehrt werden kann.

Gemäß einer weiteren Ausführungsform umfasst die Heizeinrichtung wenigstens ein korrosionsbeständiges Heizelement. Insbesondere kann die Heizeinrichtung als Plattenstapel von Widerstands-Heizelementen ausgeführt sein. Beispielsweise können hierbei Graphit- oder Siliziumkarbid-Heizelemente als plattenförmige Mäanderheizer oder als Heizstäbe zum Einsatz kommen. In Abhängigkeit von der Auslegung der Gasströmungsgeschwindigkeit, der Heizerleistung und der Oberfläche der Heizermatrix können Aufheizraten der Prozessgüter von einigen Grad Celsius pro Minute bis zu einigen Grad Celsius pro Sekunde erreicht werden.

Gemäß einer weiteren Ausführungsform ist eine Kühleinrichtung vorgesehen und bevorzugt in dem Gasströmungskreislauf angeordnet, die vorzugsweise wenigstens ein Kühlelement und insbesondere einen Plattenstapelkühler oder einen Rohrbündelkühler umfasst. Das Kühlelement kann beispielsweise mittels eines Öltemperiergeräts auf einer Temperatur von z.B. etwa 200°C gehalten werden. In Abhängigkeit von der Gasströmungsgeschwindigkeit, der Kühlerleistung und der Oberfläche der Kühleranordnung können Abkühlraten von bis zu einigen Grad Celsius pro Minute auf den Prozessgütern erreicht werden.

Gemäß einer weiteren Ausführungsform sind Gasumlenkelemente vorgesehen, durch die der Gasströmungskreislauf derart umlenkbar ist, dass entweder die Heizeinrichtung oder die Kühleinrichtung in dem Gasströmungskreislauf angeordnet ist. Die Gasumlenkelemente ermöglichen bei entsprechender Einstellung eine besonders schnelle Erwärmung bzw. Abkühlung der Prozessgüter auf eine gewünschte Temperatur.

Wie bereits erwähnt können die Prozessgüter flächige Substrate, insbesondere Glassubstrate, zum Herstellen von Halbleiterdünnschichten, vorzugsweise Chalcopyrit-Halbleiterschichten, bevorzugt I-III-VI-Verbindungshalbleiterschichten und insbesondere Cu(In,Ga)(Se,S)2-Halbleiterschichten, beispielsweise für Solarzellen, umfassen. Allgemein besteht ein Chalcopyrit-Halbleiter aus Elementen der Gruppen I, III und VI, wobei als Element der Gruppe I z.B. Cu, als Element der Gruppe III z.B. In und/oder Ga und als Element der Gruppe VI z.B. Se und/oder S gewählt werden kann.

Eine Vorrichtung der voranstehend beschriebenen Art eignet sich somit beispielsweise zur Herstellung von Halbleiterdünnschichten, insbesondere für Solarzellen.

Weiterer Gegenstand der Erfindung ist außerdem ein Verfahren zum Prozessieren von gestapelten Prozessgütern, insbesondere bei mittleren bis hohen Temperaturen, mit den Merkmalen des Anspruchs 11, durch welches sich die voranstehend genannten Vorteile entsprechend erreichen lassen.

Weiterer Gegenstand der Erfindung ist ferner eine Prozessanlage zum Prozessieren von gestapelten Prozessgütern mit wenigstens einer Prozessvorrichtung der voranstehend beschriebenen Art, wobei die Prozessvorrichtung eine Beladungsöffnung, durch die der Prozessgutstapel in die Gasleiteinrichtung einbringbar ist, und eine Entladungsöffnung aufweist, durch die der Prozessgutstapel aus der Gasleiteinrichtung entnehmbar ist.

Vorteilhafterweise umfasst die Prozessanlage eine weitere Prozessvorrichtung, die relativ zu der einen Prozessvorrichtung benachbart angeordnet ist und eine Beladungsöffnung aufweist, welche mit der Entladungsöffnung der einen Prozessvorrichtung ausgerichtet ist. Die Beladungsöffnung und/oder Entladungsöffnung können bzw. kann dabei durch eine Tür, insbesondere ein Plattenventil, verschließbar sein.

Bevorzugt ist die weitere Prozessvorrichtung eine Abkühlvorrichtung, die eine Kühleinrichtung aufweist, welche in einem Gasströmungskreislauf angeordnet ist, der in einer evakuierbaren Prozesskammer der Abkühlvorrichtung durch eine Gasfördereinrichtung erzeugt wird. Außerdem kann die Prozessanlage eine der in Durchlaufrichtung gesehen ersten Prozessvorrichtung vorgelagerte Einschleuskammer umfassen.

Durch die benachbarte Anordnung mehrerer Prozessvorrichtungen bildet die Prozessanlage eine Durchlaufanlage für den zu prozessierenden Prozessgutstapel. Es handelt sich gewissermaßen also um eine "Batch-Inline-Anlage", welche die Vorteile eines kontinuierlichen Durchlaufbetriebs mit denen eines Batch-Betriebs in sich vereint.

Es versteht sich von selbst, dass die Anzahl der Prozessvorrichtungen nicht auf zwei beschränkt ist. Vielmehr kann die Prozessanlage beispielsweise eine Anzahl n von Prozessvorrichtungen und eine Anzahl m von Abkühlvorrichtungen umfassen, wobei n und m natürliche Zahlen sind und wobei lediglich für die einfachste Variante einer Batch-Inline-Kombinations-Prozessanlage n = m = 1 gilt.

Nachfolgend wird die Erfindung rein beispielhaft anhand vorteilhafter Ausführungsformen unter Bezugnahme auf die beigefügten Zeichnungen beschrieben. Es zeigen:
- Fig. 1: eine schematische Querschnittsansicht einer erfindungsgemäßen Prozessvorrichtung;
- Fig. 2: eine schematische Längsschnittansicht der Prozessvorrichtung entlang der Linie A-A von Fig. 1;
- Fig. 3: eine schematische Längsschnittansicht einer erfindungsgemäßen Prozessanlage mit einer Prozessvorrichtung der in Fig. 1 und 2 gezeigten Art und einer daneben angeordneten Abkühlvorrichtung; und
- Fig. 4: eine schematische Längsschnittansicht noch einer alternativen Ausführungsform einer erfindungsgemäßen Prozessanlage mit einer der Prozessvorrichtung vorgelagerten Einschleuskammer und einer der Prozessvorrichtung nachgelagerten Abkühlvorrichtung.

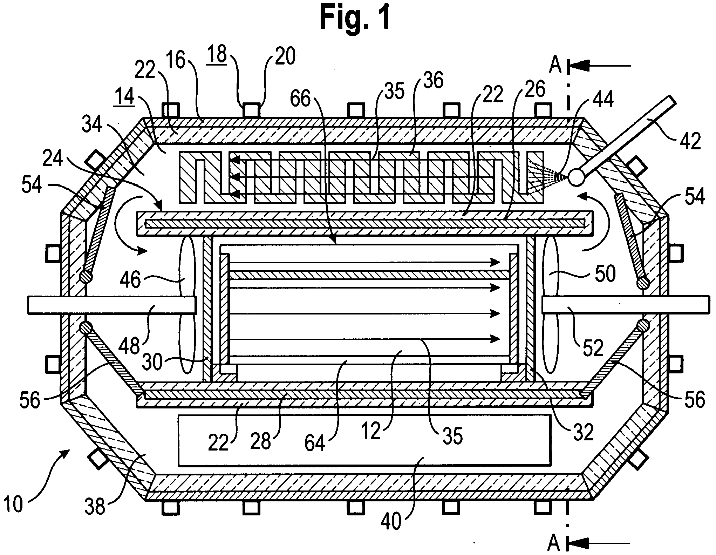

In Fig. 1 ist eine erfindungsgemäße Prozessvorrichtung 10 dargestellt, die zum Ausbilden von Cu(In, Ga)(Se, S)₂-Halbleiterdünnschichten auf Glassubstraten 12 vorgesehen ist, welche zur Herstellung von Solarzellen verwendet werden sollen.

Die Prozessvorrichtung 10 umfasst eine evakuierbare Prozesskammer 14, die durch eine Prozesskammerwand 16 begrenzt ist. Die Prozesskammerwand 16 ist aus Edelstahl gebildet und wird durch eine Temperiereinrichtung 18 auf einer Temperatur im Bereich von 150°C bis 250°C gehalten.

Im vorliegenden Ausführungsbeispiel ist die Temperiereinrichtung 18 durch an der Außenseite der Prozesskammer 14 angebrachte, insbesondere an der Prozesskammerwand 16 angeschweißte, die Prozesskammer 14 mäanderförmig umlaufende Rohrleitungen 20 gebildet, durch welche ein geeignetes Heißöl strömt. Alternativ oder zusätzlich kann das Heißöl aber auch durch in die Prozesskammerwand 16 entsprechend eingelassene Kanäle (nicht gezeigt) strömen. Zusätzlich kann die Außenseite der Prozesskammerwand 16 mit einem thermischen Isolationsmaterial versehen sein.

An einer Innenseite der Prozesskammerwand 16 ist die Prozesskammer 14 zumindest annähernd vollständig mit einem korrosionsfesten partikelarmen thermischen Isolationsmaterial 22 ausgekleidet, welches bis zu einer Temperatur von mindestens 1000 °C hitzebeständig ist. Bei dem thermischen Isolationsmaterial 22 kann es sich um eine Keramik, eine Glaskeramik, um Graphit, einschließlich eines Faserstoffes, wie z.B. Carbon Fiber Inforced Carbon (CFC), oder um einen keramikfaserhaltigen Isolationsstoff, der z.B. aus SiO₂- und Al₂O₃-Fasern besteht, handeln.

In einem mittleren Bereich der Prozesskammer 14 ist eine Gasleiteinrichtung 24 angeordnet. Die Gasleiteinrichtung 24 umfasst eine obere Trennplatte 26 und eine untere Trennplatte 28. Zusätzlich zu der oberen und unteren Trennplatte 26, 28 können eine vordere und eine hintere Trennplatte (nicht gezeigt) vorgesehen sein. Üblicherweise fehlen aber die vordere und hintere Trennplatte, da deren Funktion durch die thermisch isolierten Kammerseitenwände einschließlich dort angeordneter Türen oder Vakuumventile erfüllt werden.

Die obere und untere Trennplatte 26, 28 sowie gegebenenfalls auch die vordere und hintere Trennplatte sind vorzugsweise aus einem korrosionsfesten Material gebildet, wie beispielsweise einem Keramikmaterial, wie z.B. Siliziumkarbid oder Siliziumnitrid, oder einem Glaskeramikmaterial. Außerdem sind alle Trennplatten jeweils mit einer Schicht des bereits genannten thermischen Isolationsmaterials 22 verkleidet.

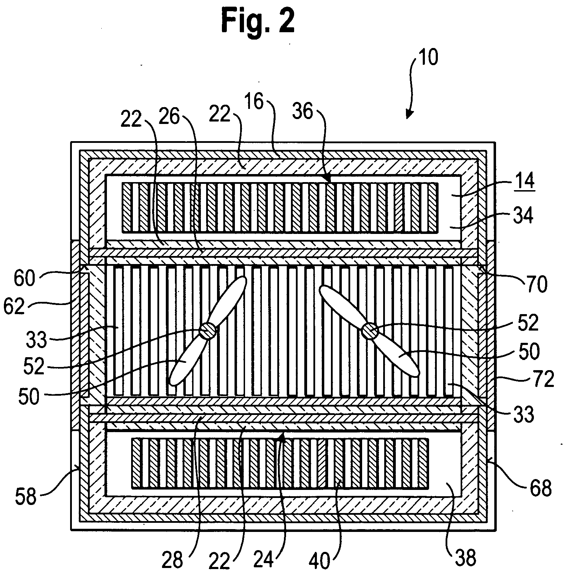

Die Gasleiteinrichtung 24 umfasst ferner eine erste Verteilereinrichtung 30, die im Bereich einer ersten (in Fig. 1 linken) Stirnseite der Gasleiteinrichtung 24 zwischen den Trennplatten 26, 28 angeordnet ist, und eine zweite Verteilereinrichtung 32, die im Bereich einer zweiten (in Fig. 1 rechten) Stirnseite der Gasleiteinrichtung 24 zwischen den Trennplatten 26, 28 angeordnet ist. Die Verteilereinrichtungen 30, 32 sind jeweils aus einem korrosionsfesten Material, wie z.B. Siliziumkarbid, Siliziumnitrid oder einem Glaskeramikmaterial, gebildet. Wie Fig. 2 zu entnehmen ist, handelt es sich bei den Verteilereinrichtungen 30, 32 im vorliegenden Ausführungsbeispiel jeweils um eine Platte, die mit einer Vielzahl von vertikal und insbesondere mit den Glassubstraten 12 ausgerichteten Schlitzen 33 versehen ist. Alternativ oder zusätzlich kann in der oder jeder Platte auch eine Vielzahl von Löchern ausgebildet sein.

Die obere und untere Trennplatte 26, 28, die erste und zweite Verteilereinrichtung 30, 32 und gegebenenfalls auch die nicht gezeigte vordere und hintere Trennplatte bilden eine Einhausung für die Substrate 12, die zumindest annähernd spaltdicht ausgeführt ist, damit ein durch die Gasleiteinrichtung 24 strömender Gasstrom 35 in der Einhausung geführt wird und nicht seitlich aus dieser entweichen kann.

In einem zwischen der oberen Trennplatte 26 und der Prozesskammerwand 16 gelegenen oberen Kammerbereich 34 ist eine Heizeinrichtung 36 angeordnet, beispielsweise eine Siliziumkarbid-Mäander-Heizermatrix, während in einem zwischen der unteren Trennplatte 28 und der Prozesskammerwand 16 gelegenen unteren Kammerbereich 38 eine Kühleinrichtung 40, beispielsweise ein Plattenstapelkühler, angeordnet ist. Alternativ kann die Kühleinrichtung 40 in dem oberen Kammerbereich 34 und die Heizeinrichtung 36 in dem unteren Kammerbereich 38 angeordnet sein.

Im Bereich eines Endes (in Fig. 1 des rechten Endes) der Heizeinrichtung 36 ist eine Gaseinlasseinrichtung 42 angeordnet, die sich durch die Prozesskammerwand 16 erstreckt und es ermöglicht, der Prozesskammer 14 von außen ein Prozessgas 44 zuzuführen, im vorliegenden Ausführungsbeispiel ein selen- oder schwefelhaltiges Gas, wie z.B. H₂S- oder H₂Se-Gas. Obwohl die Gaseinlasseinrichtung 42 grundsätzlich an einer beliebigen Stelle der Prozesskammer 14 angeordnet sein kann, ist die in Fig. 1 gezeigte Anordnung besonders vorteilhaft, da das durch die Gaseinlasseinrichtung 42 zugeführte Prozessgas 44 bei Normalbetrieb zunächst die Heizeinrichtung 36 durchläuft und somit unmittelbar nach dem Eintreten in die Prozesskammer 14 erwärmt wird.

Im Bereich der ersten Stirnseite der Gasleiteinrichtung 24 ist wenigstens ein erster Ventilator 46 der ersten Verteilereinrichtung 30 vorgelagert, welcher durch eine sich durch die Prozesskammerwand 16 erstreckende erste Antriebswelle 48 angetrieben wird. Auf der gegenüberliegenden Seite der Gasleiteinrichtung 24 sind zwei zweite Ventilatoren 50 im Bereich der zweiten Verteilereinrichtung 32 angeordnet, welche durch sich durch die Prozesskammerwand 16 erstreckende zweite Antriebswellen 52 angetrieben werden.

Sowohl die ersten und zweiten Ventilatoren 46, 50 als auch die ersten und zweiten Antriebswellen 48, 52 sind aus einem korrosionsbeständigen Material, wie z.B. einem Keramikmaterial, insbesondere Siliziumnitrid oder Siliziumkarbid, gebildet. Die ersten Ventilatoren 46 werden so angetrieben, dass sie Gas in die Gasleiteinrichtung 24 hineinfördern, während die zweiten Ventilatoren 50 gleichzeitig so betrieben werden, dass sie Gas aus der Gasleiteinrichtung 24 hinausfördern. Durch den Betrieb der Ventilatoren 46, 50 wird somit ein Gasströmungskreislauf erzeugt, der in der in Fig. 1 gezeigten Ansicht entgegen dem Uhrzeigersinn orientiert ist. D.h. das durch die Gaseinlasseinrichtung 42 in die Prozesskammer 14 eingeleitete Prozessgas 44 strömt von rechts nach links durch die Heizeinrichtung 36, dann nach unten und von links nach rechts durch die Gasleiteinrichtung 24 und anschließend nach oben und erneut von rechts nach links durch die Heizeinrichtung 36.

Zur zusätzlichen Steuerung der Gasströmung in der Prozesskammer 14 sind ein oberes Paar von umschaltbaren Gasumlenkelementen 54 und ein unteres Paar von umschaltbaren Gasumlenkelementen 56 vorgesehen. Die oberen Gasumlenkelemente 54 sind so angeordnet, dass sie die Strömung des Prozessgases 44 aus der Gasleiteinrichtung 24 in den oberen Kammerbereich 34 bzw. aus dem oberen Kammerbereich 34 in die Gasleiteinrichtung 24 zulassen, drosseln oder vollständig verhindern können. Entsprechend sind die unteren Gasumlenkelemente 56 so angeordnet, dass sie eine Strömung des Prozessgases 44 aus der Gasleiteinrichtung 24 in den unteren Kammerbereich 38 bzw. aus dem unteren Kammerbereich 38 in die Gasleiteinrichtung 24 zulassen, drosseln oder vollständig verhindern können.

In der in Fig. 1 dargestellten Situation befinden sich die oberen Gasumlenkelemente 54 in einer offenen Stellung, sodass eine Zirkulation des Prozessgases durch den oberen Bereich der Prozesskammer 14, d.h. durch die Gasleiteinrichtung 24 und die Heizeinrichtung 36 möglich ist. Die unteren Gasumlenkelemente 56 befinden sich hingegen in einer geschlossenen Stellung, das heißt sie verhindern eine Zirkulation des Prozessgases 44 durch den unteren Bereich der Prozesskammer 14 und insbesondere durch die Kühleinrichtung 40. In der in Fig. 1 dargestellten Situation zirkuliert also ausschließlich heißes Prozessgas, was zur Einhaltung einer gewünschten Prozesstemperatur, beispielsweise im Bereich von 400 °C bis 600 °C, beiträgt. Werden die oberen Gasumlenkelemente 54 dagegen geschlossen und die unteren Gasumlenkelemente 56 geöffnet, so durchströmt das Prozessgas 44 die Kühleinrichtung 40, und die Glassubstrate 12 werden auf eine reduzierte Temperatur, z.B. 250 °C, abgekühlt.

Zur Beladung der Prozesskammer 14 weist die Prozessvorrichtung 10 an seiner Vorderseite eine in die Prozesskammerwand 16 eingelassene Beladungsöffnung 60 auf, die durch ein Plattenventil 62 oder eine andere geeignete Tür verschließbar ist.

Die zu prozessierenden Glassubstrate 12 werden in einem Träger 64, z.B. einem auf Rollen gelagerten Wagen, vertikal orientiert und zueinander beabstandet angeordnet, um einen Prozessgutstapel 66, auch Batch genannt, zu bilden. Der Prozessgutstapel 66 wird durch die Beladungsöffnung 60 in die Prozesskammer 14 hinein gefahren und in der Gasleiteinrichtung 24 untergebracht. Nach dem Verschließen der Beladungsöffnung 60 erfolgt ein wiederholtes Evakuieren und Spülen der Prozesskammer 14, um den Sauerstoff und Wassergehalt in der Prozesskammer 14 soweit wie möglich zu reduzieren.

Zur Evakuierung der Prozesskammer 14 ist die Prozesskammerwand 16 mit einer geeigneten Absaugöffnung (nicht gezeigt) versehen, an welche eine ebenfalls nicht gezeigte Pumpenanlage angeschlossen ist. Zum Spülen der Prozesskammer 14 ist ein geeigneter Gaseinlass in der Prozesskammerwand 16 vorgesehen, durch den ein Spülgas, wie z.B. N₂, in die Prozesskammer 14 eingeleitet werden kann.

Sobald die Atmosphäre in der Prozesskammer 14 einen geeigneten definierten Ausgangszustand aufweist, werden die Ventilatoren 46, 50 eingeschaltet, die Heizeinrichtung 36 aktiviert und Stickstoffgas in die Prozesskammer 14 eingelassen. Die oberen Gasumlenkelemente 54 sind zu diesem Zeitpunkt geöffnet und die unteren Gasumlenkelemente 56 geschlossen, wie es in Fig. 1 dargestellt ist, um eine Erwärmung der Glassubstrate 12 zu ermöglichen.

Sobald die Temperatur in der Prozesskammer 14 die erforderliche Reaktionsstarttemperatur erreicht hat, wird ein selenhaltiges, z.B. H₂Se-haltiges, Prozessgas 44 durch die Gaseinlasseinrichtung 42 in die Prozesskammer 14 eingeleitet. Die Reaktionsstarttemperatur kann zwischen Raumtemperatur und 400 °C liegen.

Nachdem das Prozessgas 44 für eine bestimmte Zeitdauer bei einem gewünschten Temperaturprofil, einer gewünschten Gaskonzentration, z.B. im Bereich von 0,2% bis 50%, und einer gewünschten Gasströmungsgeschwindigkeit über die Glassubstrate 12 hinweggeströmt ist, werden die Ventilatoren 46, 50 abgeschaltet und die Prozesskammer 14 evakuiert.

Während anschließend ein schwefelhaltiges, z.B. H₂S-haltiges, Prozessgas 44 durch die Gaseinlasseinrichtung 42 in die Prozesskammer 14 eingeleitet wird, werden die Ventilatoren 46, 50 wieder eingeschaltet. Die Prozesstemperatur wird weiter erhöht, z.B. auf zwischen 400 °C und 600 °C, und für eine bestimmte Zeitdauer auf einer Solltemperatur gehalten. Dabei werden die gewünschte Gasströmungsgeschwindigkeit und Gaskonzentration eingeregelt, letztere z.B. im Bereich von 0,2% bis 50%.

Nach Beendigung des Heizvorgangs werden die oberen Gasumlenkelemente 54 in ihre geschlossene Stellung gebracht und die unteren Gasumlenkelemente 56 geöffnet, sodass das Prozessgas 44 nun durch die Kühleinrichtung 40 geleitet wird und eine Abkühlung der Glassubstrate 12 auf eine Temperatur beispielsweise im Bereich von 350°C bis 150°C, beispielsweise 250°C, erfolgt.

Nach einem erneuten Abpumpen der Prozesskammer 14 und Befüllung mit Stickstoff ist die Prozessierung des Prozessgutstapels 66 abgeschlossen, sodass dieser aus der Prozesskammer 14 entnommen werden kann.

Die mit der Prozessvorrichtung 10 erreichbaren in einem weiten Bereich einstellbaren Aufheiz- und Abkühlraten - beispielsweise Aufheizraten im Bereich von weniger als 1 K/min bis 60 K/min und je nach Auslegung der Prozesskammer 14 auch darüber - ermöglichen es, die Prozessierung des Prozessgutstapels 66 in der Prozesskammer 14, d.h. im vorliegenden Ausführungsbeispiel die Selenisierung und Sulfurisierung der Prozessgüter, in weniger als 2 Stunden durchzuführen.

Grundsätzlich ist es möglich, den Prozessgutstapel 66 durch die Beladungsöffnung 60 an der Vorderseite 58 der Prozessvorrichtung 10 zu entnehmen.

Im vorliegenden Ausführungsbeispiel weist die Prozessvorrichtung 10 an ihrer Rückseite 68 jedoch eine in die Prozesskammerwand 16 eingelassene Entladungsöffnung 70 auf, die ähnlich wie die Beladungsöffnung 60 durch ein Plattenventil 72 oder eine andere geeignete Tür verschließbar ist. Die Ausrüstung der Prozessvorrichtung 10 mit einer Beladungsöffnung 60 und einer gegenüberliegenden Entladungsöffnung 70 hat den Vorteil, dass die Prozessvorrichtung 10 als Durchlaufvorrichtung verwendet und mit weiteren Bearbeitungsvorrichtungen gekoppelt werden kann.

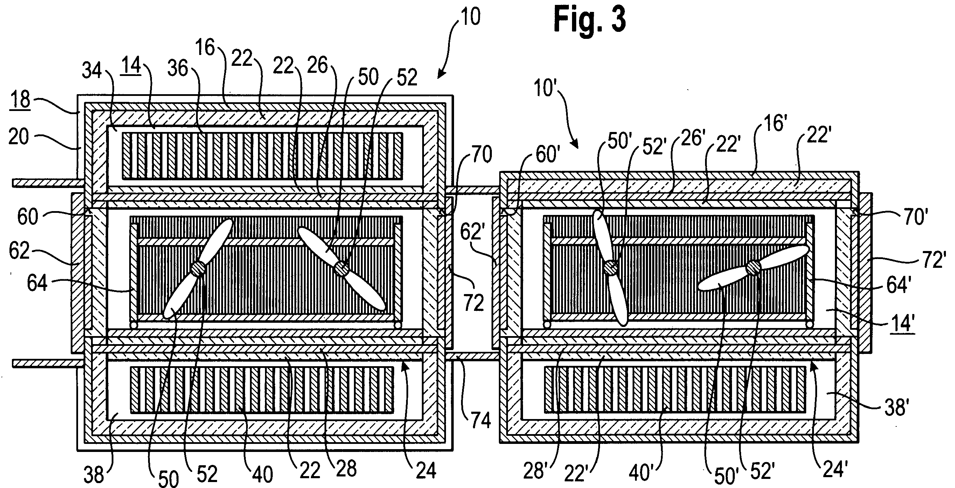

In Fig. 3 ist beispielsweise eine Prozessanlage gezeigt, die eine Prozessvorrichtung 10 und eine ausgangsseitig daran angeschlossene Abkühlvorrichtung 10' umfasst. Die Abkühlvorrichtung 10' ist ähnlich wie die Prozessvorrichtung 10 ausgebildet mit dem einzigen Unterschied, dass der obere Kammerbereich 34 mit der darin angeordneten Heizeinrichtung 36 fehlt. Da die Abkühlvorrichtung 10' ausschließlich zum Abkühlen der Glassubstrate 12 vorgesehen ist und ein Kühlgas, insbesondere ein Inertgas, wie z.B. Stickstoffgas, ausschließlich durch die Gasleiteinrichtung 24' und den die Kühleinrichtung 40' umfassenden unteren Kammerbereich 38' strömen soll, fehlen außerdem die oberen und unteren Gasumlenkelemente 54, 56. Der besseren Übersichtlichkeit halber sind in Fig. 3 keine zweiten Verteilereinrichtungen 32 dargestellt.

Die Abkühlvorrichtung 10' ist über einen Verbindungsabschnitt 74 mit der Prozessvorrichtung 10 gekoppelt und derart neben dieser angeordnet, dass eine Beladungsöffnung 60' der Abkühlvorrichtung 10' mit der Entladungsöffnung 70 der Prozessvorrichtung 10 ausgerichtet ist. Die Beladungsöffnung 60' der Abkühlvorrichtung 10' kann durch ein Plattenventil 62' gleichzeitig mit oder unabhängig von der Entladungsöffnung 70 der Prozessvorrichtung 10 geöffnet und geschlossen werden.

Durch die Anordnung der Prozessvorrichtung 10 und der Abkühlvorrichtung 10' in Reihe ist es möglich, den Prozessgutstapel 66 nach beendeter Prozessierung in der Prozessvorrichtung 10 durch die Entladungsöffnung 70 und die Beladungsöffnung 60' in die Abkühlvorrichtung 74 zu bewegen.

Nach dem Einbringen des Prozessgutstapels 66 in die Abkühlvorrichtung 10' wird das Plattenventil 72 wieder geschlossen und die Prozessvorrichtung 10 mit einem neuen Prozessgutstapel 66 bestückt.

Gleichzeitig kann der erste Prozessgutstapel 66, der sich nun in der Abkühlvorrichtung 10' befindet, noch weiter abgekühlt werden, z.B. bis auf 80 °C, indem durch Betätigung der Ventilatoren 50' zirkulierendes Stickstoffgas an den Glassubstraten 12 vorbei und durch die Kühleinrichtung 40' geleitet wird. Nach einer abschließenden Evakuierung und letzten Befüllung der Abkühlvorrichtung 10' kann der Prozessgutstapel 66 durch eine Entladungsöffnung 70' aus der Abkühlvorrichtung 10' entnommen werden. Die Abkühlvorrichtung 10' ist nun zur Aufnahme des nächsten Prozessgutstapels 66 aus der Prozessvorrichtung 10 bereit.

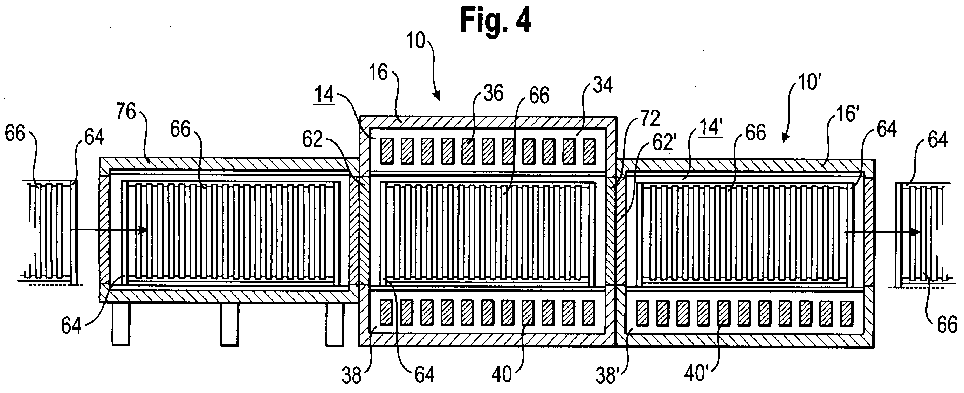

Wie in Fig. 4 gezeigt ist, kann der Prozessvorrichtung 10 eine Einschleuskammer 76 vorgelagert sein, durch welche verhindert wird, dass bei der Beladung der Prozessvorrichtung 10 mit einem Prozessgutstapel 66 Umgebungsatmosphäre in die Prozesskammer 14 eindringt.

Ferner kann ein Transportmechanismus zur Bewegung des den Prozessgutstapel 66 tragenden Trägers 64 durch die Prozessanlage eine Einschiebemechanik zum Einschieben des Trägers 64 und Prozessgutstapels 66 aus der Einschleuskammer 76 in die Prozesskammer 14 sowie eine Herausziehmechanik zum Herausziehen des Trägers 64 und Prozessgutstapels 66 aus der Prozesskammer 14 in die Abkühlvorrichtung 10' umfassen. Auf diese Weise kann verhindert werden, dass die bewegten Teile des Transportmechanismus mit den heißen und korrosiven Bereichen der Prozessanlage in Kontakt gelangen.

Mittels der voranstehend beschriebenen Durchlauf-Stapel-Prozessierung, auch Inline-Batch-Prozessierung genannt, ist es möglich, in einer Gesamtzykluszeit von deutlich weniger als 2 Stunden die gewünschten Chalcopyrit-Halbleiterdünnschichten auf den Glassubstraten 12 auszubilden.

### Bezugszeichenliste

- 10: Prozessvorrichtung
- 12: Glassubstrat
- 14: Prozesskammer
- 16: Prozesskammerwand
- 18: Temperiereinrichtung
- 20: Rohrleitung
- 22: thermisches Isolationsmaterial
- 24: Gasleiteinrichtung
- 26: obere Trennplatte
- 28: untere Trennplatte
- 30: erste Verteilereinrichtung
- 32: zweite Verteilereinrichtung
- 33: Schlitze
- 34: oberer Kammerbereich
- 35: Gasstrom
- 36: Heizeinrichtung
- 38: unterer Kammerbereich
- 40: Kühleinrichtung
- 42: Gaseinlasseinrichtung
- 44: Prozessgas
- 46: erster Ventilator
- 48: erste Antriebswelle
- 50: zweiter Ventilator
- 52: zweite Antriebswelle
- 54: oberes Gasumlenkelement
- 56: unteres Gasumlenkelement
- 58: Vorderseite
- 60: Beladungsöffnung
- 62: Plattenventil
- 64: Träger
- 66: Prozessgutstapel
- 68: Rückseite
- 70: Entladungsöffnung
- 72: Plattenventil
- 74: Verbindungsabschnitt
- 76: Einschleuskammer

## Patentansprüche

1. Prozessvorrichtung (10) zum Prozessieren von gestapelten Prozessgütern (12) mit einer evakuierbaren Prozesskammer (14) zur Aufnahme eines Prozessgases (44), die eine Temperiereinrichtung (18) umfasst, um zumindest einen Teilbereich einer Wand (16) der Prozesskammer (14) auf einer vorgegebenen Temperatur zu halten, einer Gasfördereinrichtung (46, 50) zum Erzeugen eines Gasströmungskreislaufes in der Prozesskammer (14) durch erzwungene Konvektion, einer in dem von der Gasfördereinrichtung (46, 50) erzeugten Gasströmungskreislauf angeordneten Heizeinrichtung (36) zum Aufheizen des Gases, und einer Gasleiteinrichtung (24), die zur Aufnahme des Prozessgutstapels (66) ausgebildet und in der Prozesskammer (14) derart angeordnet ist, dass mindestens ein Teil des erzeugten Gasströmungskreislaufes durch die Gasleiteinrichtung (24) hindurch verläuft, wobei an einer Innenseite der Prozesskammerwand (16) ein thermisches Isolationsmaterial (22) vorgesehen ist, das unter Prozessbedingungen reaktionsbeständig ist.

2. Prozessvorrichtung (10) nach Anspruch 1, **dadurch gekennzeichnet, dass**
die Gasleiteinrichtung (24) mindestens eine obere Trennplatte (26), die einen ersten Kammerbereich (34) in der Prozesskammer (14) oberhalb der Gasleiteinrichtung (24) definiert, und eine untere Trennplatte (28) aufweist, die einen zweiten Kammerbereich (38) in der Prozesskammer (14) unterhalb der Gasleiteinrichtung (24) definiert, wobei die Oberflächen der Gasleiteinrichtung (24) mit einem thermischen Isolationsmaterial (22) versehen sind, das unter Prozessbedingungen reaktionsbeständig ist.

3. Prozessvorrichtung (10) nach Anspruch 1 oder 2, **dadurch gekennzeichnet, dass**
die Gasleiteinrichtung (24) zumindest eine Verteilereinrichtung (30, 32) zur flächig gleichmäßigen Verteilung der Gasströmung aufweist.

4. Prozessvorrichtung (10) nach Anspruch 3, **dadurch gekennzeichnet, dass**
der Prozessgutstapel (66) stromabwärts von der Verteilereinrichtung (30) angeordnet ist.

5. Prozessvorrichtung (10) nach Anspruch 3 oder 4, **dadurch gekennzeichnet, dass**
die Verteilereinrichtung (30, 32) durch eine mit Schlitzen (33) und/oder Löchern versehene Platte gebildet ist.

6. Prozessvorrichtung (10) nach einem der vorherigen Ansprüche, **dadurch gekennzeichnet, dass**
die Gasfördereinrichtung wenigstens einen Ventilator (46) umfasst, der ein reaktionsbeständiges Material aufweist, wobei der Ventilator (46) bevorzugt im Bereich einer der Stirnseiten des Prozessgutstapels (66) angeordnet ist und/oder an einer Antriebswelle(48) befestigt ist, die in die Prozesskammer (14) hineinreicht und die vorzugsweise aus einem reaktionsbeständigen Material besteht.

7. Prozessvorrichtung (10) nach Anspruch 6, **dadurch gekennzeichnet, dass** mindestens ein weiterer Ventilator (50) im Bereich der anderen Stirnseite des Prozessgutstapels (66) angeordnet ist.

8. Prozessvorrichtung (10) nach einem der vorherigen Ansprüche, **gekennzeichnet durch** eine Gaseinlasseinrichtung (42) zum Einleiten eines schwefel- oder selenhaltigen Gases in den Gasströmungskreislauf.

9. Prozessvorrichtung (10) nach einem der vorherigen Ansprüche, **dadurch gekennzeichnet, dass**
die Heizeinrichtung (36) wenigstens ein reaktionsbeständiges Heizelement umfasst, welches Graphit- oder Siliziumkarbid-Widerstandsheizelemente umfasst.

10. Prozessvorrichtung (10) nach Anspruch 9, **dadurch gekennzeichnet, dass**
die Graphit- oder Siliziumkarbid-Widerstandsheizelemente als plattenförmige Mäanderheiz-Stapel oder als Bündel von Heizstäben ausgebildet sind.

11. Prozessvorrichtung (10) nach einem der vorherigen Ansprüche, **gekennzeichnet durch** eine in dem Gasströmungskreislauf angeordnete Kühleinrichtung (40).

12. Prozessvorrichtung (10) nach Anspruch 11, **dadurch gekennzeichnet, dass**
die Kühleinrichtung temperierbar im Bereich einer Raumtemperatur bis 250°C ist und wenigstens ein Kühlelement und/oder einen Plattenstapelkühler oder einen Rohrbündelkühler umfasst.

13. Prozessvorrichtung (10) nach Anspruch 11 oder 12, **gekennzeichnet durch** Gasumlenkelemente (54, 56), **durch** die der Gasströmungskreislauf derart umlenkbar ist, dass entweder die Heizeinrichtung (36) oder die Kühleinrichtung (40) in dem Gasströmungskreislauf angeordnet ist.

14. Verfahren zum Prozessieren von gestapelten Prozessgütern (12), wobei
der Prozessgutstapel (66) während einer Prozessierphase in einer Gasleiteinrichtung (24) aufgenommen ist, die in einer ein Gas aufnehmenden Prozesskammer (14), bei der an der Innenseite der Prozesskammerwand ein thermisches Isolationsmaterial vorgesehen ist, das unter Prozessbedingungen reaktionsbeständig ist, angeordnet ist, mittels einer Temperiereinrichtung (18) zumindest ein Teilbereich der Wand (16) der Prozesskammer (14) auf einer vorgegebenen Temperatur gehalten wird, ein Gasströmungskreislauf in der Prozesskammer (14) mittels erzwungener Konvektion derart erzeugt wird, dass zumindest ein Teil des erzeugten Gasströmungskreislaufes durch die Gasleiteinrichtung (24) hindurch verläuft, und das Gas mittels einer in dem Gasströmungskreislauf angeordneten Heizeinrichtung (36) aufgeheizt wird.

15. Verfahren nach Anspruch 14,
**dadurch gekennzeichnet, dass** während der Prozessierphase ein Prozessgas (44), das schwefel- oder selenhaltig ist und z.B. H₂S- oder H₂Se-Gas umfasst, durch eine Gaseinlasseinrichtung (42) in die Prozesskammer (14) eingeleitet wird.

16. Verfahren nach Anspruch 14 oder 15, **dadurch gekennzeichnet, dass**
die Prozessgüter flächige Substrate, insbesondere vorbeschichtete Glassubstrate (12), zum Herstellen von Halbleiterdünnschichten für Solarzellen, umfassen.

17. Verfahren nach Anspruch 16, **dadurch gekennzeichnet, dass**
die Halbleiterdünnschichten Chalcopyrit-Halbleiterschichten, bevorzugt I-III-VI-Verbindungshalbleiterschichten und insbesondere Cu(In,Ga)(Se,S)₂-Halbleiterschichten umfassen.

18. Prozessanlage zum Prozessieren von gestapelten Prozessgütern (12) mit mindestens einer Prozessvorrichtung (10) nach einem der Ansprüche 1 bis 13, **dadurch gekennzeichnet, dass** die Prozessvorrichtung (10) eine Beladungsöffnung (60), durch die der Prozessgutstapel (66) in die Gasleiteinrichtung (24) einbringbar ist, und eine Entladungsöffnung (70) aufweist, durch die der Prozessgutstapel (66) aus der Gasleiteinrichtung (24) entnehmbar ist.

19. Prozessanlage nach Anspruch 18, **gekennzeichnet durch**
eine weitere Prozessvorrichtung (10'), die relativ zu der einen Prozessvorrichtung (10) benachbart angeordnet ist und eine Beladungsöffnung (60') aufweist, die mit der Entladungsöffnung (70) der einen Prozessvorrichtung (10) ausgerichtet ist.

## Claims

1. A processing device (10) for processing stacked processed goods (12) having an evacuatable processing chamber (14) for receiving a process gas (44), which comprises a tempering device (18) in order to keep at least a partial region of a wall (16) of the processing chamber (14) at a predetermined temperature, a gas conveying device (46, 50) for creating a circulating gas flow in the processing chamber (14) by forced convection, a heating device (36) arranged in the circulating gas flow created by the gas conveying device (46, 50) for heating up the gas, and a gas guiding device (24) which is configured for receiving the processed goods stack (66) and which is arranged in the processing chamber (14) such that at least part of the circulating gas flow which is created extends through the gas guiding device (24), wherein the inside of the processing chamber wall (16) is provided with a thermal insulating material (22) which is unreactive under processing conditions.

2. The processing device (10) according to Claim 1, **characterized in that** the gas guiding device (24) has at least one upper dividing plate (26) which defines a first chamber area (34) in the processing chamber (14) above the gas guiding device (24), and a lower dividing plate (28) which defines a second chamber area (38) in the processing chamber (14) below the gas guiding device (24), wherein the surfaces of the gas guiding device (24) are provided with a thermal insulation material (22) which is unreactive under processing conditions.

3. The processing device (10) according to Claim 1 or 2, **characterized in that** the gas guiding device (24) has at least one distribution device (30, 32) for uniform planar distribution of the gas flow.

4. The processing device (10) according to Claim 3, **characterized in that** the processed goods stack (66) is arranged downstream of the distribution device (30).

5. The processing device (10) according to Claim 3 or 4, **characterized in that** the distribution device (30, 32) is formed by a plate which is provided with slits (33) and/or holes.

6. The processing device (10) according to any one of the preceding claims, **characterized in that**
the gas conveying device includes at least one fan (46) which comprises an unreactive material, wherein the fan (46) is preferably arranged in the region of one of the front ends of the processed goods stack (66) and/or is attached to a drive shaft (48) which extends into the processing chamber (14) and which is preferably made of an unreactive material.

7. The processing device (10) according to Claim 6, **characterized in that** at least one other fan (50) is arranged in the region of the other front end of the processed goods stack (66).

8. The processing device (10) according to any one of the preceding claims, **characterized by** a gas inlet device (42) for feeding a sulfur-containing or selenium-containing gas into the circulating gas flow.

9. The processing device (10) according to any one of the preceding claims, **characterized in that**
the heating device (36) comprises at least one unreactive heating element which comprises graphite or silicon carbide resistive heating elements.

10. The processing device (10) according to Claim 9, **characterized in that** the graphite or silicon carbide resistive heating elements are configured as plate-shaped meander heating stacks or as bundles of heating rods.

11. The processing device (10) according to any one of the preceding claims, **characterized by** a cooling unit (40) which is arranged in the circulating gas flow.

12. The processing device (10) according to Claim 11, **characterized in that** the cooling unit is temperature-controllable within a range from room temperature to 250°C and comprises at least one cooling element and/or a plate stack cooler or a rod bundle cooler.

13. The processing device (10) according to Claim 11 or 12, **characterized by** gas deflecting elements (54, 56), through which the circulating gas flow can be deflected in such a way that either the heating device (36) or the cooling unit (40) is arranged in the circulating gas flow.

14. A method for processing stacked processed goods (12), wherein the processed goods stack (66) is received during a processing phase in a gas guiding device (24) which is arranged in a processing chamber (14) receiving a gas, wherein the inside of the processing chamber wall is provided with a thermal insulation material which is unreactive under processing conditions, at least a partial region of the wall (16) of the processing chamber (14) is kept at a predetermined temperature by means of a tempering device (18), a circulating gas flow is created in the processing chamber (14) by means of forced convection such that at least part of the circulating gas flow created extends through the gas guiding device (24), and the gas is heated up by means of a heating device (36) arranged in the circulating gas flow.

15. The method according to Claim 14,
**characterized in that** a process gas (44) which contains sulfur or selenium and e.g. comprises H₂S or H₂Se gas, is fed into the processing chamber (14) by a gas inlet device (42) during the processing phase.

16. The method according to Claim 14 or 15, **characterized in that** the processed goods comprise planar substrates, in particular pre-coated glass substrates (12), for manufacturing semiconductor thin layers for solar cells.

17. The method according to Claim 16, **characterized in that** the semiconductor thin layers comprise chalcopyrite semiconductor layers, preferably I-III-VI connecting semiconductor layers and in particular Cu(In,Ga)(Se,S)₂ semiconductor layers.

18. A processing system for processing stacked processed goods (12) with at least one processing device (10) according to any one of Claims 1 to 13, **characterized in that** the processing device (10) has a loading aperture (60) through which the processed goods stack (66) can be brought into the gas guiding device (24), and has an unloading aperture (70) through which the processed goods stack (66) can be removed from the gas guiding device (24).

19. The processing system according to Claim 18, **characterized by** another processing device (10') which is arranged adjacent to the one processing device (10) and which has a loading aperture (60') which is aligned with the unloading aperture (70) of the one processing device (10).

## Revendications

1. Dispositif de traitement (10) pour le traitement de marchandises de traitement empilées (12) avec une chambre de traitement évacuable (14) pour la réception d'un gaz de traitement (44), laquelle comprend un dispositif de régulation de température (18) afin de maintenir à une température prescrite au moins une zone partielle d'une paroi (16) de la chambre de traitement (14), un dispositif de transport de gaz (46, 50) pour la génération d'un circuit de flux de gaz dans la chambre de traitement (14) par convection forcée, un dispositif de chauffage (36) disposé dans le circuit de flux de gaz généré par le dispositif de transport de gaz (46, 50) pour le chauffage du gaz, et un dispositif de guidage de gaz (24), lequel est formé pour la réception de la pile de marchandises de traitement (66) et disposé dans la chambre de traitement (14) de telle sorte qu'au moins une partie du circuit de flux de gaz généré traverse le dispositif de guidage de gaz (24), un matériau d'isolation thermique (22) étant prévu sur un côté intérieur de la paroi de chambre de traitement (16), lequel est résistant aux réactions dans les conditions de traitement.

2. Dispositif de traitement (10) selon la revendication 1, **caractérisé en ce que** le dispositif de guidage de gaz (24) présente au moins une plaque de séparation supérieure (26), laquelle définit une première zone de chambre (34) dans la chambre de traitement (14) au-dessus du dispositif de guidage de gaz (24), et une plaque de séparation inférieure (28), laquelle définit une deuxième zone de chambre (38) dans la chambre de traitement (14) au-dessous du dispositif de guidage de gaz (24), les surfaces du dispositif de guidage de gaz (24) étant munies d'un matériau d'isolation thermique (22), lequel est résistant aux réactions dans les conditions de traitement.

3. Dispositif de traitement (10) selon la revendication 1 ou 2, **caractérisé en ce que** le dispositif de guidage de gaz (24) présente au moins un dispositif de distribution (30, 32) pour la répartition régulière en surface du flux de gaz.

4. Dispositif de traitement (10) selon la revendication 3, **caractérisé en ce que** la pile de marchandises de traitement (66) est disposée en aval du dispositif de distribution (30).

5. Dispositif de traitement (10) selon les revendications 3 ou 4, **caractérisé en ce que** le dispositif de distribution (30, 32) est formé par une plaque munie de fentes (33) et/ou de trous.

6. Dispositif de traitement (10) selon l'une des revendications précédentes, **caractérisé en ce que**
le dispositif de transport de gaz comprend au moins un ventilateur (46), lequel présente un matériau résistant aux réactions, le ventilateur (46) étant disposé de préférence dans la zone d'un des côtés frontaux de la pile de marchandises de traitement (66) et/ou fixé à un arbre d'entraînement (48), lequel pénètre dans la chambre de traitement (14) et se compose de préférence d'un matériau résistant aux réactions.

7. Dispositif de traitement (10) selon la revendication 6, **caractérisé en ce qu'**au moins un ventilateur supplémentaire (50) est disposé dans la zone de l'autre côté frontal de la pile de marchandises de traitement (66).

8. Dispositif de traitement (10) selon l'une des revendications précédentes, **caractérisé par** un dispositif d'arrivée de gaz (42) pour l'introduction d'un gaz comprenant du soufre ou du sélénium dans le circuit du flux de gaz.

9. Dispositif de traitement (10) selon l'une des revendications précédentes, **caractérisé en ce que**
le dispositif de chauffage (36) comprend au moins un élément de chauffage résistant aux réactions, lequel comprend des éléments de chauffage par résistance au graphite ou au carbure de silicium.

10. Dispositif de traitement (10) selon la revendication 9, **caractérisé en ce que** les éléments de chauffage par résistance au graphite ou au carbure de silicium sont formés comme pile de chauffage à méandres en forme de plaque ou comme groupes de baguettes chauffantes.

11. Dispositif de traitement (10) selon l'une des revendications précédentes, **caractérisé par** un dispositif de refroidissement (40) disposé dans le circuit de flux de gaz.

12. Dispositif de traitement (10) selon la revendication 11, **caractérisé en ce que** la température du dispositif de refroidissement peut être régulée dans la plage d'une température ambiante jusqu'à 250 °C et comprend au moins un élément de refroidissement et/ou un refroidisseur de pile de plaques ou un refroidisseur à faisceau tubulaire.

13. Dispositif de traitement (10) selon les revendications 11 ou 12, **caractérisé par** des éléments de déviation de gaz (54, 56) par lesquels le circuit de flux de gaz peut être dévié de telle sorte que soit le dispositif de chauffage (36), soit le dispositif de refroidissement (40) sont disposés dans le circuit de flux de gaz.

14. Procédé pour le traitement de marchandises de traitement empilées (12), la pile de marchandises de traitement (66) étant réceptionnée pendant une phase de traitement dans un dispositif de guidage de gaz (24), lequel est disposé dans une chambre de traitement (14) réceptionnant un gaz, sur laquelle un matériau d'isolation thermique est prévu sur le côté intérieur de la paroi de chambre de traitement, lequel matériau est résistant aux réactions dans les conditions de traitement, au moins une zone partielle de la paroi (16) de la chambre de traitement (14) étant maintenue à une température prescrite au moyen d'un dispositif de régulation de température (18), un circuit de flux de gaz étant généré par convection forcée dans la chambre de processus (14) de telle sorte qu'au moins une partie du circuit de flux de gaz généré traverse le dispositif de guidage de gaz (24), et le gaz étant chauffé au moyen d'un dispositif de chauffage (36) disposé dans le circuit de flux de gaz.

15. Procédé selon la revendication 14,
**caractérisé en ce que**, pendant la phase de traitement, un gaz de traitement (44), lequel comprend du soufre ou du sélénium et par exemple du gaz H₂S ou H₂Se, est introduit dans la chambre de traitement (14) à travers un dispositif d'arrivée de gaz (42).

16. Procédé selon la revendication 14 ou 15, **caractérisée en ce que** les marchandises de traitement comprennent des substrats plans, en particulier des substrats en verres prérevêtus (12), pour la fabrication de couches minces semi-conductrices pour des cellules photovoltaïques.

17. Procédé selon la revendication 16, **caractérisé en ce que** les couches minces semi-conductrices comprennent des couches semi-conductrices en chalcopyrite, de préférence des couches semi-conductrices composites I-III-VI et en particulier des couches semi-conductrices Cu(In,Ga)(Se,S)₂.

18. Installation de traitement pour le traitement de marchandises de traitement (12) avec au moins un dispositif de traitement (10) selon l'une des revendications 1 à 13, **caractérisée en ce que** le dispositif de traitement (10) présente une ouverture de chargement (60) par laquelle la pile de marchandises de traitement (66) peut être introduite dans le dispositif de guidage de gaz (24) et une ouverture de déchargement (70), par laquelle la pile de marchandises de traitement (66) peut être retirée du dispositif de guidage de gaz (24).

19. Installation de traitement selon la revendication 18, **caractérisée par** un autre dispositif de traitement (10'), lequel est disposé de façon voisine au dispositif de traitement (10) et présente une ouverture de chargement (60'), laquelle est alignée avec l'ouverture de déchargement (70) du dispositif de traitement (10).
